(19)

Europäisches
Patentamt
European
Patent Office
Office européen
des brevets

(11) **EP 2 930 753 A1**

(12) **EUROPEAN PATENT APPLICATION**

(43) Date of publication:
**14.10.2015 Bulletin 2015/42**

(51) Int Cl.:
**H01L 29/744** (2006.01)       **H01L 29/423** (2006.01)

(21) Application number: **14164075.5**

(22) Date of filing: **09.04.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **ABB Technology AG
8050 Zürich (CH)**

(72) Inventors:
• **Homola, Jaroslav
27201 Kladno (CZ)**

• **Muller, Ilja
15200 Praha 5 (CZ)**
• **Matejec, Jan
15000 Praha 5 (CZ)**
• **Podzemsky, Jiri
43401 Most (CZ)**

(74) Representative: **ABB Patent Attorneys
C/o ABB Schweiz AG
Intellectual Property (CH-LC/IP)
Brown Boveri Strasse 6
5400 Baden (CH)**

(54) **Turn-off power semiconductor device**

(57)     The invention relates to a turn-off power semiconductor device (100) comprising a plurality of thyristor cells (2). In the turn-off power semiconductor device (100) of the invention, the distance between a gate electrode (20) and a cathode semiconductor layer portion (22) depends on the distance of the thyristor cell (2) from a common gate contact (40). Specifically, for each pair of a first thyristor cell and a second thyristor cell of the plurality of thyristor cells (2), for which the distance between the first thyristor cell and the common gate contact (40) is smaller than the distance between the second thyristor cell and the common gate contact (40), a minimum distance between the gate electrode (20) and the cathode semiconductor layer portion (22) is smaller in the second thyristor cell than in the first thyristor cell.

FIG. 3

EP 2 930 753 A1

**Description**

Field of the invention

The invention relates to the field of power semiconductor devices and in particular to a turn-off power semiconductor device according to the preamble of claim 1.

Background of the invention

In the field of power semiconductor devices there are known turn-off power semiconductor devices such as a gate turn-off thyristor (GTO), and a gate commutated thyristor (GCT), in particular an integrated gate commutated thyristor (IGCT). There is known a reverse blocking IGCT (RB-IGCT) and a reverse-conducting IGCT (RC-IGCT).

As an example for a known turn-off power semiconductor device a prior art RC-IGCT 1 is shown in Figures 1 and 2. Such RC-IGCT is described for example in WO 2012/041958 A2. Fig. 1 illustrates a portion of the known RC-IGCT 1 in cross section and Fig. 2 shows the layout of the device in top view. The RC-IGCT 1 comprises a plurality of thyristor cells 2 and an integrated free-wheeling diode 3. All thyristor cells 2 and the integrated free-wheeling diode 3 are formed in one single wafer 10 having a first main side 11, which is the cathode side of the RC-IGCT 1, and a second main side 12, which is the anode side of the RC-IGCT 1.

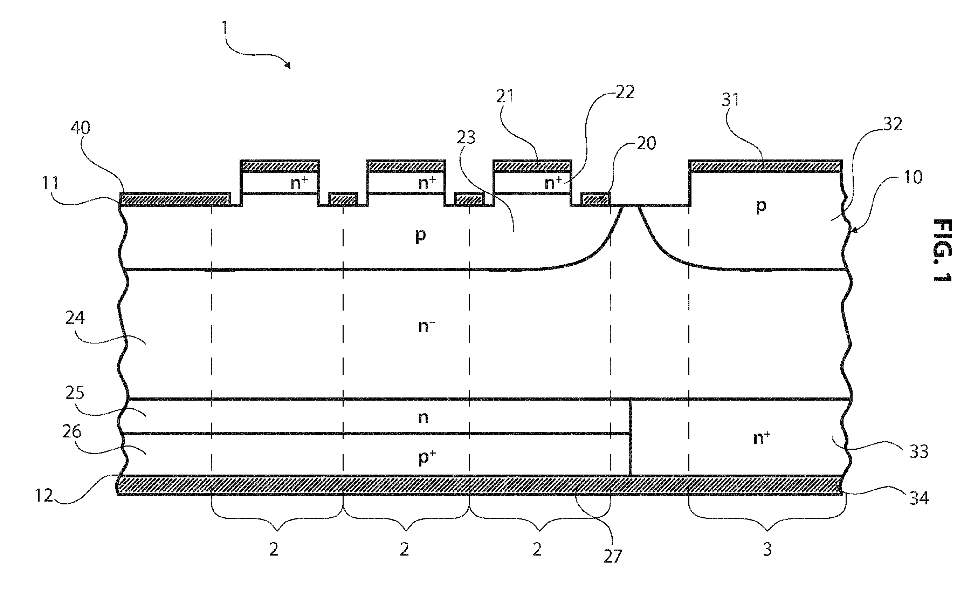

As can be seen in Fig. 1, each thyristor cell 2 comprises from the first main side 11 to the second main side 12 of the wafer 10 a first cathode electrode 21, a $n^+$-doped cathode semiconductor layer portion 22, a p-doped base semiconductor layer 23, a $n^-$-doped drift semiconductor layer 24, a buffer semiconductor layer 25, a $p^+$-doped first anode semiconductor layer 26 and a first anode electrode 27. The cathode semiconductor layer portions 22 of the plurality of thyristor cells 2 form a first cathode semiconductor layer. Therein the buffer semiconductor layer 25 has a rising doping concentration towards the second main side 12, whereas the drift semiconductor layer has typically a constant doping concentration.

Further, each thyristor cell 2 has a gate electrode 20 which is arranged on the first main side 11 of the wafer 10 lateral to the cathode semiconductor layer portion 22 and contacting the base semiconductor layer 23, but separated from the first cathode electrode 21 and the cathode semiconductor layer portion 22. Therein, the term "lateral" relates to the position in a lateral direction which is a direction parallel to the first main side 11.

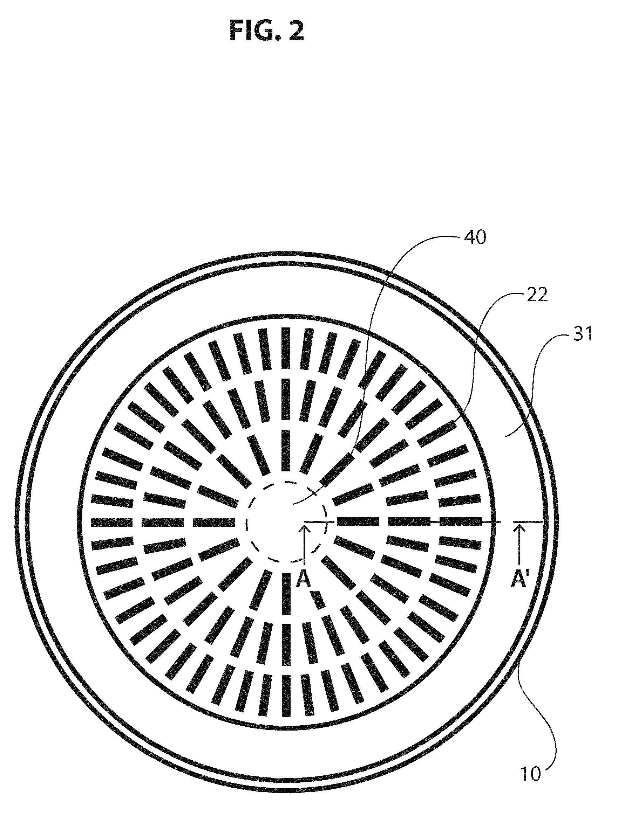

In the circumferential edge region of the wafer 10 there is arranged the integrated single free-wheeling diode 3, a cross section of which along the line AA' in Fig. 2 can also be seen in Fig. 1. The free-wheeling diode 3 comprises from the first main side 11 to the second main side 12 of the wafer 10 a second anode electrode 31, a p-doped second anode semiconductor layer 32, a $n^+$-doped second cathode semiconductor layer 33, which is separated from the p-doped second anode semiconductor layer 32 by the $n^-$-doped drift semiconductor layer 24, and a second cathode electrode 34.

The arrangement of the plurality of thyristor cells 2 in the RC-IGCT 1 is illustrated in Fig. 2 which shows a top view onto the first main side 11 of the wafer. The cathode semiconductor layer portions 22 of the RC-IGCT 1 are formed in the shape of strips with its longitudinal direction aligned in radial direction which is a direction extending from the center of the device and being parallel to the first main side 11 of the wafer 10. Therein, the center of the device is the center of the first main side of the circular wafer 10. Further, strips shall be understood as layers, which have in one direction, which is their longitudinal direction, a longer extension than in the other directions by having two longer sides, which are typically arranged parallel to each other. The plurality of strip-shaped cathode semiconductor layer portions 22 are arranged in concentric rings around the center of the device. In the center region of the wafer 10 there is arranged a common gate contact 40 to which all gate electrodes 20 of the plurality of thyristor cells 2 are electrically connected. The gate electrodes 20 of the thyristor cells 2, the common gate contact 40 and the connections there between are implemented as a gate metallization layer surrounding all the cathode semiconductor layer portions 22.

For turning off the RC-IGCT, a short control gate current pulse is supplied through the common gate contact 40 to the gate electrodes 20 of the plurality of thyristor cells 2. The uniformity of the current distribution to the plurality of thyristor cells 2 is an important parameter for the turn-off performance of the RC-IGCT 1. In the RG-IGCT described above with Figures 1 and 2, the common gate contact 40 is located on the first main side 11 in the center thereof. The thyristor cells 2 in an outer ring are turned off by a lower gate current than thyristor cells of an inner ring. Therefore the charge under the cathode semiconductor layer portions of an inner ring is removed faster than that under the cathode semiconductor layer portions of an outer ring. Accordingly, the thyristor cells of an outer ring remain in an on-state longer and consequently can be overheated what may finally result in destruction of the whole device.

The same problem of non-uniform turn-off of thyristor cells due to an inhomogeneous gate current distribution exists not only for the RC-IGCT but also for any other turn-off semiconductor power device comprising a plurality of thyristor cells.

To homogenize the current distribution it is known a turn-off power semiconductor device where the common gate contact has the shape of a concentric ring located on the first main side at the perimeter of the wafer. In another turn-off power semiconductor device as described in EP 0 592 991 A1, the common gate contact is located between two rings of thyristor cells somewhere between the center and the perimeter of the device. This known approaches have, however, the disadvantage that they can only alleviate the local inhomogeneities of the gate current pulse to the plurality of thyristor cells but cannot avoid them. Further, the ring-shaped common gate contact consumes more of the active area of the device than devices with a central common gate contact. Finally, also housing of devices with a ring shaped common gate contact is more complicated and involves higher costs compared to housing a device with central common gate contact.

Summary of the invention

It is the object of the invention improve the turn-off performance of a turn-off power semiconductor device having a plurality of thyristor cells by decreasing the inhomogeneities of the gate current density in the turn-off power semiconductor device.

The object of the invention is attained by a turn-off power semiconductor device according to claim 1.

In the turn-off power semiconductor device of the invention the distance between the gate electrode and the cathode semiconductor layer portion depends on the distance of the thyristor cell from the common gate contact. Specifically, for each pair of a first thyristor cell and a second thyristor cell of the plurality of thyristor cells, for which the distance between the first thyristor cell and the common gate contact is smaller than the distance between the second thyristor cell and the common gate contact, a minimum distance between the gate electrode and the cathode semiconductor layer portion is smaller in the second thyristor cell than in the first thyristor cell.

The decreasing distance between gate electrode and the cathode semiconductor layer portion in a thyrisor cell with increasing distance of the thyristor cells from the common gate contact results in a decreasing serial resistance of the base semiconductor layer connecting the gate electrode to the cathode semiconductor layer portion. In this way the decreased distance between the gate electrode and the cathode semiconductor layer portion with increasing distance of the thyristor cells from the common gate contact can compensate the increasing voltage drop with increasing distance from the common gate contact.

As a result, the inhomogeneities of the gate current density in the device can be avoided and the thyristor cells can be turned off at the same time to improve the turn-off performance of the turn-off power semiconductor device accordingly.

Further developments of the invention are specified in the dependent claims.

In an exemplary embodiment of the turn-off power semiconductor device, the common gate contact is arranged in the center of the device on the first main side. Compared to other designs where the main gate contact is formed as a ring either at the perimeter of the wafer or somewhere between the center and the perimeter of the wafer, the design with the main contact arranged in the center of the device consumes less active area of the device. Further, housing the device with the common gate contact in the center is less complicated and, therefore, costs for housing are lower compared to the costs for housing of devices with a ring shaped common gate contact.

In a preferred embodiment of the turn-off power semiconductor device, the cathode semiconductor layer portions of the plurality of thyristor cells are arranged with rotational symmetry around the center of the device on the first main side. In such arrangement with rotational symmetry, the main current distribution and the gate current distribution have also a rotational symmetry and can be made more uniform.

In an exemplary embodiment of the turn-off power semiconductor device the cathode semiconductor layer portions of the plurality of thyristor cells are formed on the first main side as strips placed in concentric rings around the center of the device, the longitudinal axis of each strip extending along a radial direction which is a direction extending from the center of the device in a plane parallel to the first main side. Such arrangement can improve the uniformity of the main current through the device and minimize the voltage drop of the electrical connection between common gate contact and gate electrodes along the radial direction extending from the center of the device. Moreover, such arrangement can optimize the usage of the active area of the device.

In one exemplary embodiment the distance between the gate electrode and the cathode semiconductor layer portion is decreasing along the longitudinal axis of the strip-shaped cathode semiconductor layer portions with increasing distance from the common gate contact in each one of the plurality of thyristor cells. In this way a voltage drop in the gate electrode along the longitudinal axis of each single thyristor cell can be efficiently compensated.

In a preferred embodiment the distance between the gate electrode and the cathode semiconductor layer portion is constant along the longitudinal axis in each one of the plurality of thyristor cells, respectively. Such layout with a single constant distance for each thyristor cell is more easy to produce and decreases the costs for manufacturing the device, whereas the gate current distribution in the different thyristor cells is approximately equalised due to the decreasing distances of the gate electrode from the cathode semiconductor layer portion for thyristor cells with increasing distance to the common gate contact.

In a preferred embodiment the base semiconductor layer between the cathode semiconductor layer portion and the gate electrode of each thyristor cell is covered by a passivation oxide layer to define the distance between the gate electrode and the first cathode semiconductor layer of each thyristor cell. With such structure, the distance between the gate electrode and the cathode semiconductor layer portion can be defined precisely.

Brief description of the drawings

Detailed embodiments of the invention will be explained below with reference to the accompanying figures, in which

Fig. 1 is a cross section of a portion of a turn-off power semiconductor device known from the prior art along a line AA' in Fig. 2;

Fig. 2 is top view of the turn-off power semiconductor device shown in Fig. 1;

Fig. 3 is a cross section of a portion of a turn-off power semiconductor device according to a first embodiment;

Fig. 4A is top view of the turn-off power semiconductor device shown in Fig. 3;

Fig. 4B is an enlarged view of a portion of the top view shown in Fig. 4A;

Fig. 5 is a cross section of a turn-off power semiconductor device according to a second embodiment;

Fig. 6 is a cross section of a turn-off power semiconductor device according to a third embodiment; and

Fig. 7 is a an enlarged top view of a portion of a turn-off power semiconductor device according to a fourth embodiment and a graph which shows the distance between the gate electrode and the cathode semiconductor layer portion as a function of the distance r from the common gate electrode.

The reference signs used in the figures and their meanings are summarized in the list of reference signs. Generally, similar elements have the same reference signs throughout the specification. The described embodiments are meant as examples and shall not limit the scope of the invention.

Detailed Description of preferred embodiments

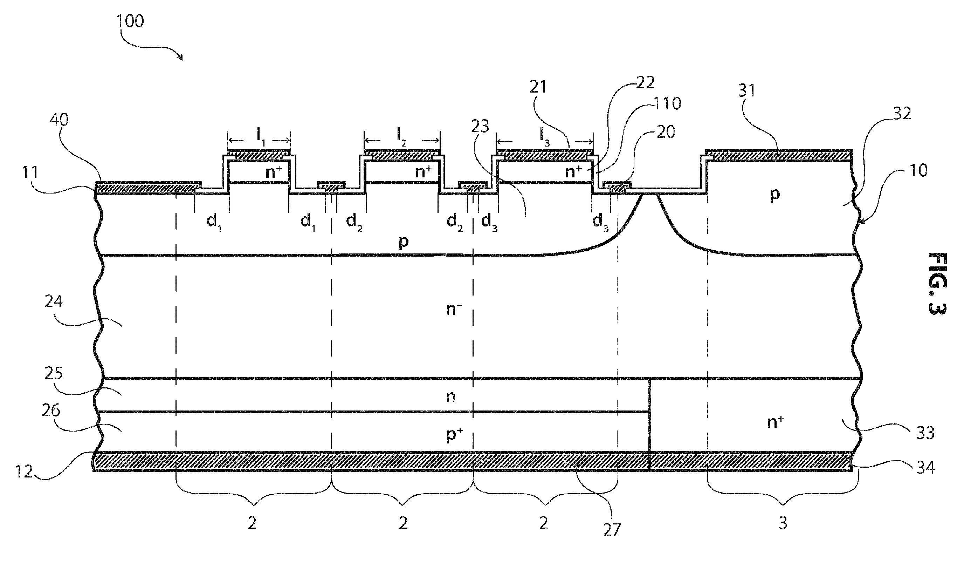

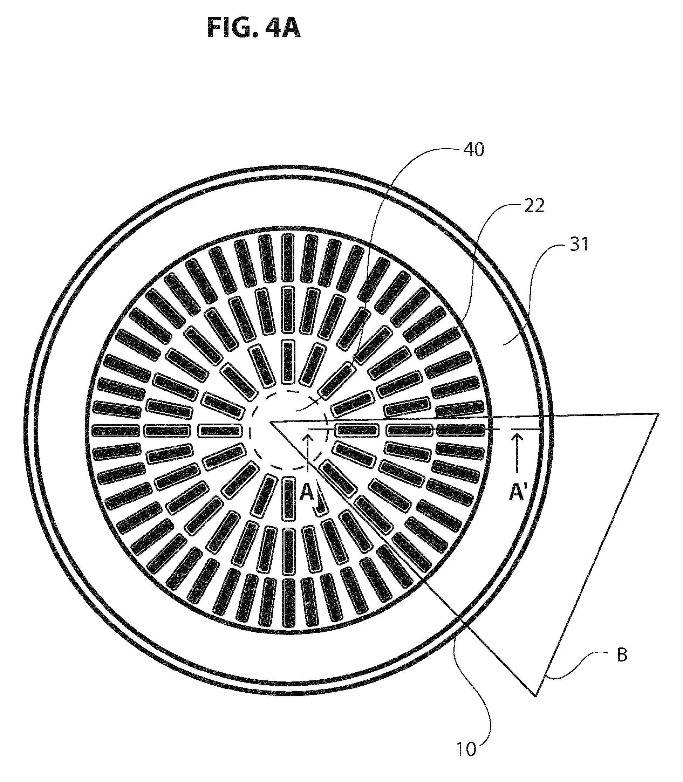

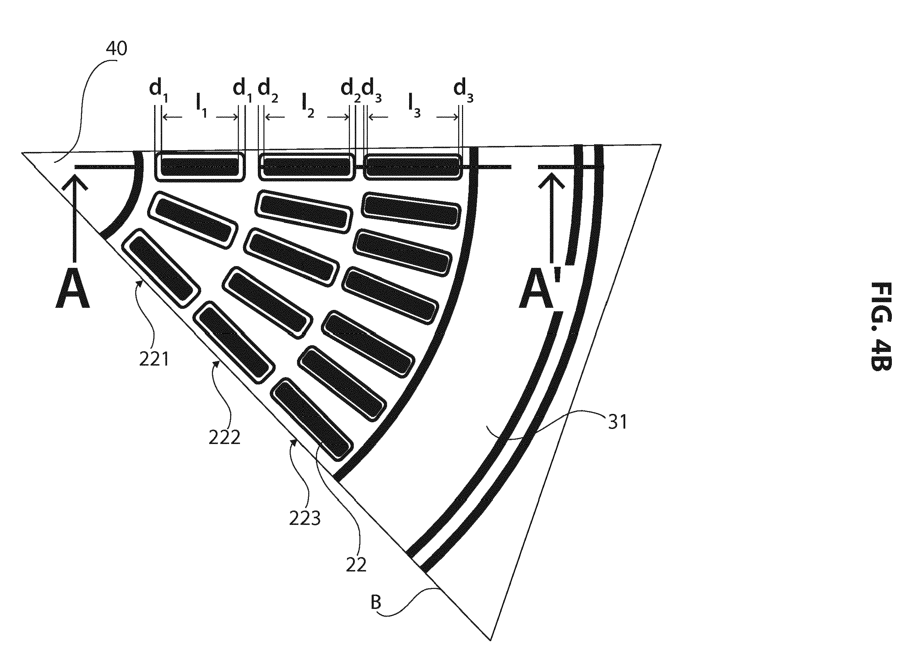

Figures 3 and 4 show a turn-off power semiconductor device according to a first embodiment. Fig. 3 is a cross section of a portion of the turn-off power semiconductor device along the line AA' in Fig. 4A, which is a top view of the turn-off power semiconductor device shown in Fig. 3.

The turn-off power semiconductor device according to the first embodiment is a reverse-conducting IGCT (RC-IGCT) 100 similar to the RC-IGCT 1 known from the prior art as shown in Figures 1 and 2. The RC-IGCT 100 according to the first embodiment comprises a plurality of thyristor cells 2 and an integrated free-wheeling diode 3. All thyristor cells 2 and the integrated free-wheeling diode 3 are formed in one single wafer 10 having a first main side 11 and a second main side 12.

As can be seen in Fig. 3, each thyristor cell 2 comprises from the first main side 11 to the second main side 12 of the wafer 10 a first cathode electrode 21, a $n^+$-doped cathode semiconductor layer portion 22, a p-doped base semiconductor layer 23, a $n^-$-doped drift semiconductor layer 24, a buffer semiconductor layer 25, a $p^+$-doped first anode semiconductor layer 26 and a first anode electrode 27. The cathode semiconductor layer portions 22 of the plurality of thyristor cells 2 form a first cathode semiconductor layer. Therein the buffer semiconductor layer 25 has a rising doping concentration towards the second main side 12, whereas the drift semiconductor layer 24 has approximately a constant low doping concentration.

Further, each thyristor cell 2 has a gate electrode 20 which is arranged on the first main side 11 of the wafer 10 lateral to the cathode semiconductor layer portion 22 and contacting the base semiconductor layer 23, but separated from the first cathode electrode 21 and the cathode semiconductor layer portion 22. Therein, the term "lateral" relates to the position in a lateral direction which is a direction parallel to the first main side 11.

In the circumferential edge region of the wafer 10 there is arranged the integrated single free-wheeling diode 3, a cross section of which along the line AA' in Fig. 4A can also be seen in Fig. 3. The free-wheeling diode 3 comprises from the first main side 11 to the second main side 12 of the wafer 10 a second anode electrode 31, a p-doped second anode semiconductor layer 32, an $n^+$-doped second cathode semiconductor layer 33, which is separated from the p-doped second anode semiconductor layer 32 by the $n^-$-doped drift semiconductor layer 24, and a second cathode electrode 34.

The arrangement of the plurality of thyristor cells 2 in the RC-IGCT 100 can be seen in Fig. 4A, which shows a top view onto the first main side 11 of the wafer 10, and in Fig. 4B, which shows an enlarged view of the portion B of the top view shown in Fig. 4A.

As in the RC-IGCT 1 shown in Figures 1 and 2, the cathode semiconductor layer portions 22 of the RC-IGCT 100 are formed in the shape of strips with its longitudinal direction aligned in radial direction, which is a direction extending from the center of the device and parallel to the first main side 11 of the wafer 10. As above in the description of the prior art, the center of the device is the center of the circular wafer 10. Further, strips shall be understood as layers, which have in one direction, which is their longitudinal direction, a longer extension than in the other directions by having two longer sides, which are typically arranged parallel to each other. The plurality of strip-shaped cathode semiconductor layer portions 22 are arranged in concentric rings 221, 222 and 223 around the center of the device. In the center region of the wafer 10 there is arranged a common gate contact 40 to which all gate electrodes 20 of the plurality of thyristor cells 2 are electrically connected. The gate electrodes 20 of the thyristor cells 2, the common gate contact 40 and the connections there between are implemented as a gate metallization layer surrounding all the cathode semiconductor layer portions 22.

Also, the upper side of the gate metallization layer is on a level lower than the upper side of the cathode electrodes 21 of the plurality of thyristor cells 2 when the first main side 11 forms an upper side of the device and the second main side 12 forms a lower side of the device.

In the RC-IGCT 100 according to the first embodiment all cathode semiconductor layer portions 22 in the innermost first ring 221 have the same length $l_1$ along its longitudinal axis, whereas all cathode semiconductor layer portions 22 in the second ring 222 have the same length $l_2$ along its longitudinal axis which is longer than $l_1$ (i.e. $l_1 < l_2$). Likewise, all cathode semiconductor layer portions 22 in the outermost third ring 223 have the same length $l_3$ along its longitudinal axis which is longer than $l_2$ (i.e. $l_2 < l_3$). The increasing length from the center toward the circumferential edge of the wafer allows an efficient use of the active area of the wafer.

Throughout the specification, the distance between the gate electrode 20 and the cathode semiconductor layer portion 22 shall be the distance in a lateral direction parallel to the first main side 11 between an edge of an interface area of the gate electrode 20 with the base semiconductor layer 23 and an edge of an interface area of the cathode semiconductor layer portion 22 with the base semiconductor layer 23. In other words, the distance between the gate electrode 20 and the cathode semiconductor layer portion 22 is a distance between the interface area of the gate electrode 20 with the base semiconductor layer 23 and an edge of an interface area of the cathode semiconductor layer portion 22 with the base semiconductor layer 23 in an orthogonal projection onto a plane parallel to the first main side 11 of the wafer 10.

Referring to Fig. 3, the surface of the base layer between the inner edges of gate electrodes 20 and the outer edges of the strip-shaped cathode semiconductor layer portions 22 is covered by a passivation oxide layer 110 to define the distance between the gate electrode 20 and the first cathode semiconductor layer portion 22 of each thyristor cell 2. The interface areas of the gate electrodes 20 and the base semiconductor layer 23 are defined by openings in the passivation oxide layer 110. Likewise, also the interface areas of the first cathode electrodes 21 and the corresponding cathode semiconductor layer portions 22 are defined by openings in the passivation oxide layer 110. The use of the passivation oxide layer 110 allows a very precise definition of the position and shape of the interface area between the gate electrode 20 and the base semiconductor layer 23 to allow for a very precise definition of the distance $d_1$, $d_2$ and $d_3$ between the gate electrodes 20 and the cathode semiconductor layer portions 22.

As shown in Fig. 4B, the distance $d_1$ between the gate electrode 20 and the cathode semiconductor layer portion 22 of each thyristor cell in the first ring 221 is constant along the whole circumferential edge of the cathode semiconductor layer portion 22. Likewise, the distance $d_2$ between the gate electrode 20 and the cathode semiconductor layer portion 22 of each thyristor cell in the second ring 222 is constant along the whole circumferential edge of the cathode semiconductor layer portion 22 and the distance $d_3$ between the gate electrode 20 and the cathode semiconductor layer portion 22 of each thyristor cell in the third ring 223 is constant along the whole circumferential edge of the cathode semiconductor layer portion 22. Therein, the distance between the gate electrode 20 and the cathode semiconductor layer portion 22 decreases from ring to ring with increasing distance from the common gate contact 40 (i.e. $d_1 > d_2 > d_3$).

Accordingly, for each single ring of the rings 221, 222, 223 shown in Fig. 4B, the layout of the thyristor cell 2 regarding the distance $d_1$, $d_2$, $d_3$ between the gate electrode 20 and the cathode semiconductor layer portion 22 and regarding the length of the strip $l_1$, $l_2$, $l_3$ is the same for all thyristor cells 2 of the respective single ring 221, 222, 223. In addition, the cathode semiconductor layer portions 22 of the plurality of thyristor cells 2 in a ring are arranged on the first main side 11 with rotational symmetry around the center of the device. The rotational symmetry allows a uniform distribution of the main current and of the gate current in different circular sectors of the circular wafer 10.

In operation of the RC-IGCT 100, a gate current pulse is supplied through the common gate contact to the gate electrodes 20 of the plurality of thyristor cells 2 to turn-off the main current flowing in the conducting state of the RC-IGCT 100 through the plurality of thyristor cells 2 from the first anode electrode 27 to the first cathode electrode 21. Due to the ohmic resistance of the gate metallization layer constituting the common gate contact 40, the gate electrodes 20 and the connections there between, a voltage drop occurs across the gate metallization layer which is increasing with increasing distance from the common gate contact 40. The total ohmic resistance which determines the current density of the gate current is the sum of the ohmic resistance of the gate metallization layer and the serial resistance of the base semiconductor layer 23 through which the gate current flows in a lateral direction parallel to the first main surface 11 towards the portions of the thyristor cells 2 carrying the main current in a direction vertical to the first main surface. The decreasing distance of the gate electrodes 20 to the cathodes semiconductor layer portions 22 decreasing with increasing distance from the common gate contact 40 has the effect that the before mentioned serial resistance of the base semiconductor layer 23 is decreasing with increasing distance from the common gate contact 40 to compensate the voltage drop which is increasing with increasing distance from the common gate contact 40. Thereby, the current density of the gate current flowing in each thyristor cell 2 can be made the same independent from the distance of the thyristor cell 2 from the common gate contact 40. A uniform current density of the gate current for all thyristor cells results in a simultaneous turn-off of all the thyristor cells. Accordingly, the turn-off performance is improved in the RC-IGCT 100 according to the first embodiment.

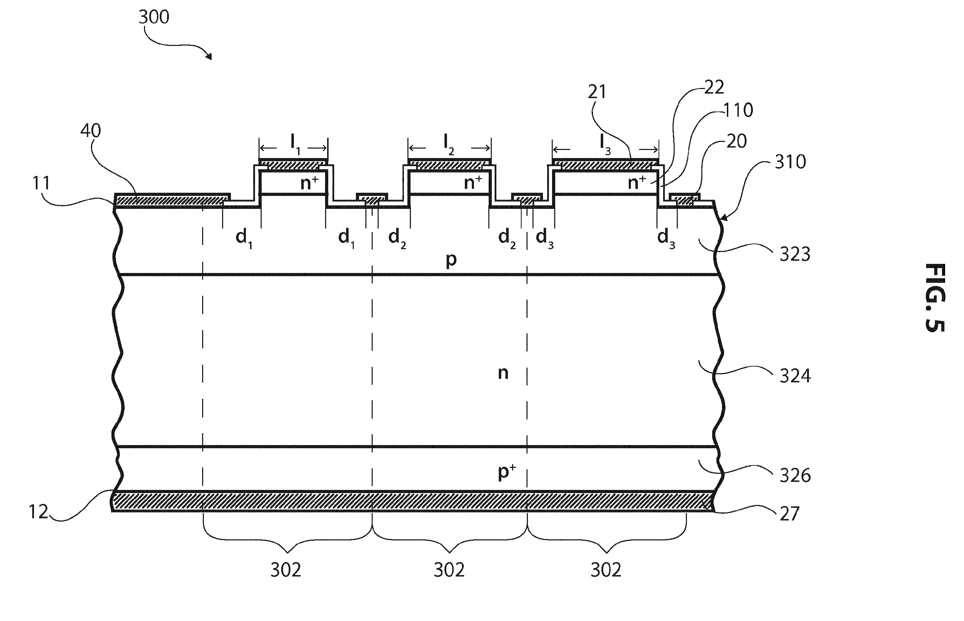

Fig. 5 shows a second embodiment of the turn-off power semiconductor device of the invention. In this second embodiment, the layout and arrangement of the gate electrodes 20 and the cathode semiconductor layer portions 22 on the first main side 11 of the wafer as described above for the first embodiment is applied to a RB-IGCT 300 (reverse blocking IGCT) as shown in Fig. 5 in cross section. The RB-IGCT 300 is another type of turn-off semiconductor power device which comprises a plurality of thyristor cells 302 like the RC-IGCT 100 according to the first embodiment. The RB-IGCT 300 differs from the RC-IGCT 100 according to the first embodiment in a different doping profile of the thyristor cells 302 across the wafer 310. In particular, the RB-IGCT does not comprise the buffer semiconductor layer between the drift semiconductor layer 324 and the anode semiconductor layer 326. Further, in the wafer 310 of the RB-IGCT 300 there is not integrated a free-wheeling diode.

Each thyristor cell of the RB-IGCT 300 shown in Fig. 5 comprises from the first main side 11 of the wafer 310 to the second main side 12 of the wafer 310 a first cathode electrode 21, a $n^+$-doped cathode semiconductor layer portion 22, a p-doped base semiconductor layer 323, a n-doped drift semiconductor layer 324, a $p^+$-doped anode semiconductor layer 326 and an first anode electrode 27. The cathode semiconductor layer portions 22 of the plurality of thyristor cells 302 form a first cathode semiconductor layer.

The different doping profiles of the thyristor cells 2 of the RC-IGCT 100 and of the thyristor cells 302 of the RB-IGCT 300 are due to optimization for different device characteristics. In the RB-IGCT 300 a smooth transition from the forward conductive state to the reverse blocking state (soft reverse recovery) is desired. As a result, the drift semiconductor layer 324 of a RB-IGCT has to be thicker than that of an optimized RC-IGCT. Also the carrier life time in the drift semiconductor layer 324 of the RB-IGCT has to be adapted by introducing low lifetime areas in regions of the drift semiconductor layer 324 near the base semiconductor layer 323 and the anode semiconductor layer 326. This can be done by proton implantation.

Like the thyristor cells 2 of the RC-IGCT 100 according to the first embodiment, each thyristor cell 302 of the RB-IGCT 300 has a gate electrode 20 which is arranged on the first main side 11 of the wafer 310 lateral to the cathode semiconductor layer portion 22 and contacting the base semiconductor layer 323, but separated from the cathode electrode 21 and the cathode semiconductor layer portion 22. Therein, the term "lateral" relates to the position in a lateral direction which is a direction parallel to the first main side 11.

The arrangement and layout of the RB-IGCT 300 with regard to the common gate contact 40, the gate electrodes 20 and the cathode semiconductor layer portions 22 on the first main side 11 of the wafer 310 is the same as in the RC-IGCT 100 as described above with reference to Figures 4A and 4B. Accordingly, the same effects with regard to uniformity of the gate current density and turn-off performance can be achieved.

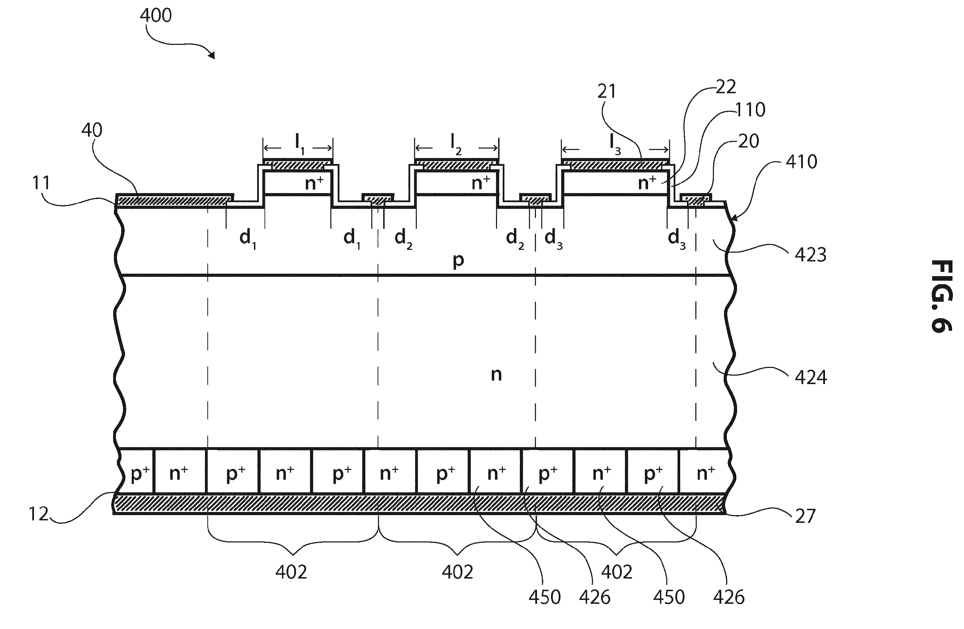

Fig. 6 shows a third embodiment of the turn-off power semiconductor device of the invention. In this third embodiment, the arrangement and layout of the gate electrodes 20 and the cathode semiconductor layer portions 22 on the first main side 11 of the wafer as described above for the first embodiment is applied to a GTO (gate turn-off thyristor) 400 as shown in Fig. 6 in cross section. The GTO 400 is another type of turn-off semiconductor power device which comprises, like the RC-IGCT 100 according to the first embodiment, a plurality of thyristor cells 402. The GTO 400 differs from the RC-IGCT 100 according to the first embodiment in a different doping profile of the thyristor cells 402 across the wafer 410. In particular, the GTO does not comprise the buffer semiconductor layer between the drift semiconductor layer 424 and the first anode semiconductor layer 426. Further, in the wafer 410 of the GTO 400 there is not integrated a free-wheeling diode. The different doping profiles of the thyristor cells 2 of the RC-IGCT 100 and of the thyristor cells 402 of the GTO 400 is mainly due to optimization for a different gate control. In the IGCT the full load main current is commutated from the cathode to the gate within a few micro-seconds during turn-off, whereas the GTO 400 is turned off with a gate current pulse of much lower gate current density.

Each thyristor cell of the GTO 400 shown in Fig. 6 comprises from the first main side 11 of the wafer 410 to the second main side 12 of the wafer 410 a cathode electrode 21, a $n^+$-doped cathode semiconductor layer portion 22, a p-doped base semiconductor layer 423, a n-doped drift semiconductor layer 424, a $p^+$-doped anode semiconductor layer 426 and an anode electrode 27. In addition there are disposed a plurality of $n^+$-doped anode short semiconductor regions 450 between the n-doped drift semiconductor layer 424 and the anode electrode 27 in the $p^+$-doped anode semiconductor layer 426. The cathode semiconductor layer portions 22 of the plurality of thyristor cells 402 form a first cathode semiconductor layer.

Further, like the thyristor cells 2 of the RC-IGCT 100 according to the first embodiment, each thyristor cell 402 of the GTO 400 has a gate electrode 20 which is arranged on the first main side 11 of the wafer 410 lateral to the cathode semiconductor layer portion 22 and contacting the base semiconductor layer 23, but separated from the first cathode electrode 21 and the cathode semiconductor layer portion 22. Therein, the term "lateral" relates to the position in a lateral direction which is a direction parallel to the first main side 11.

The arrangement and layout of the GTO 400 with regard to the common gate contact 40, the gate electrodes 20 and the cathode semiconductor layer portions 22 on the first main side 11 of the wafer 410 is the same as in the RC-IGCT 100 as described above with reference to Figures 4A and 4B. Accordingly, the same effects with regard to uniformity of the gate current density and turn-off performance can be achieved.

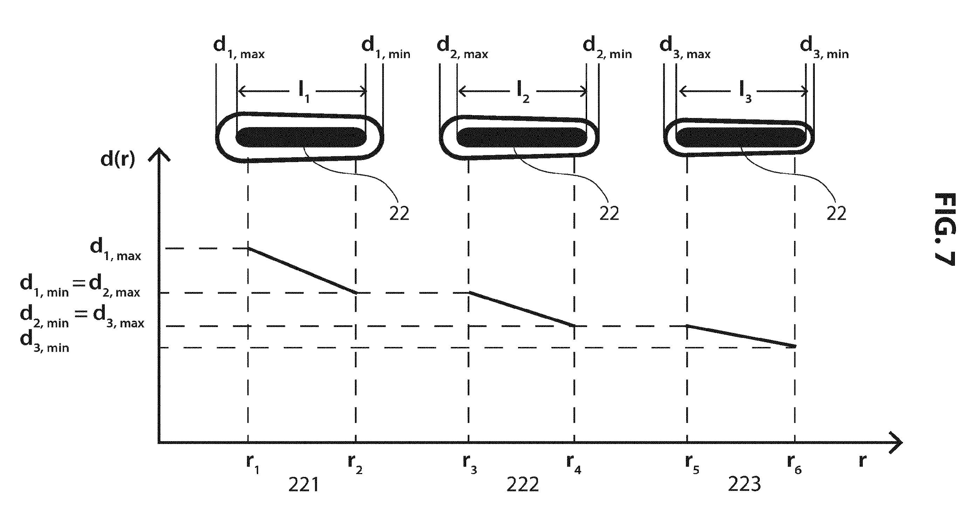

In Fig. 7 there is illustrated a modification of the gate turn-off power semiconductor devices according to the first to third embodiment, respectively. Fig. 7 shows an enlarged view of the layout of thyristor cells of three different rings in top view. It shows the cathode semiconductor layer portions 22 surrounded by gate electrodes 20. This modified embodiment differs from the first to third embodiment only in that the distance between the gate electrode 20 and the cathode semiconductor layer portion 22 of one single thyristor cell is not constant anymore along the circumferential edge of the cathode semiconductor layer portion 22. Rather, the distance between the gate electrode 20 and the cathode semiconductor layer portion 22 of one single thyristor cell decreases along the longitudinal axis of the strip-shaped cathode semiconductor portion 22 with increasing distance r from the common gate contact 40.

In Fig. 7 there is also shown a graph of the distance between the gate electrode 20 and the cathode semiconductor layer portion 22 as a function of the distance r from the common gate contact 40. As shown in Fig. 7, in a thyristor cell of the first ring 221 the distance $d_1$ between the gate electrode 20 and the cathode semiconductor layer portion 22 is decreasing along the longitudinal axis of the cathode semiconductor layer portion 22 with increasing distance r from the common gate contact 40 from a maximum distance $d_{1,max}$ to a minimum distance $d_{1,min}$. In a thyristor cell of the second ring 222, the distance $d_2$ between the gate electrode 20 and the cathode semiconductor layer portion 22 is decreasing along the longitudinal axis of the cathode semiconductor layer portion 22 with increasing distance r from the common gate contact 40 from a maximum distance $d_{2,max}$ to a minimum distance $d_{2,min}$, wherein the maximum distance $d_{2,max}$ is equal to the minimum distance $d_{1,min}$ in the thyristor cells of the first ring. In a thyristor cell of the third ring 223, the distance $d_3$ between the gate electrode 20 and the cathode semiconductor layer portion 22 is decreasing along the longitudinal axis of the cathode semiconductor layer portion 22 with increasing distance r from the common gate contact 40 from a maximum distance $d_{3,max}$ to a minimum distance $d_{3,min}$, wherein the maximum distance $d_{3,max}$ is equal to the minimum distance $d_{2,min}$ in the thyristor cells of the second ring.

While Fig. 7 shows only one thyristor cell of each one of the first to third ring, the layout of the remaining thyristor cells regarding the distance $d_1$, $d_2$, $d_3$ between the gate electrode 20 and the cathode semiconductor layer portion 22 and regarding the length of the strip $l_1$, $l_2$, $l_3$ is the same for all remaining thyristor cells of these rings, respectively.

Like explained in detail for the first embodiment, differences in voltage drop across the gate metallization layer can be compensated by the decreasing distance between gate electrode 20 and cathode semiconductor layer portion 22 with increasing distance from the common gate contact. In the embodiment there cannot only be compensated differences in the voltage drop from ring to ring but also along the longitudinal axis of each single cathode semiconductor layer portion 22.

Further modifications of the above described embodiments are possible.

In the modified embodiment described with Fig. 7, it was described that the maximum and minimum distances fulfil the following two equations:

$$(1) \qquad d_{2,max} = d_{1,min}$$

$$(2) \qquad d_{3,max} = d_{2,min}$$

However, to compensate the voltage drop along the distance separating one ring from the next on, it is also possible that these equations are modified as follows

$$(1') \qquad d_{2,max} < d_{1,min}$$

$$(2') \qquad d_{3,max} < d_{2,min}$$

Further, the embodiments were described with three rings. However, the number of rings could be any number above one.

The above embodiments were explained with specific conductivity types. The conductivity types of the semiconductor layers in the above described embodiments might be switched, so that all layers which were described as p-type layers would be n-type layers and all layers which were described as n-type layers would be p-type layers. For example, in a modified first embodiment, the thyristor cells could include a $p^+$-doped cathode semiconductor layer portion, a n-doped base semiconductor layer, a p-doped drift semiconductor layer, a $p^+$-doped buffer semiconductor layer and a n-doped first anode semiconductor layer.

All embodiments were described with a central common gate contact 40. However, the invention is not limited to such central common gate contact. It would also be possible to have ring-shaped common gate contact at the perimeter of the wafer or even between two rings somewhere between the perimeter and the center of the wafer.

It should be noted that the term "comprising" does not exclude other elements or steps and that the indefinite article "a" or "an" does not exclude the plural. Also elements described in association with different embodiments may be combined.

List of reference signs

| | |
|---|---|
| 1 | reverse conducting IGCT (RC-IGCT) |
| 2 | thyristor cell |
| 3 | integrated free-wheeling diode |
| 10 | wafer |
| 11 | first main side |
| 12 | second main side |
| 20 | gate electrode |
| 21 | first cathode electrode |
| 22 | cathode semiconductor layer portion |
| 23 | base semiconductor layer |
| 24 | drift semiconductor layer |
| 25 | buffer semiconductor layer |
| 26 | first anode semiconductor layer |
| 27 | first anode electrode |
| 31 | second anode electrode |
| 32 | second anode semiconductor layer |
| 33 | second cathode semiconductor layer |
| 34 | second cathode electrode |
| 40 | common gate contact |
| 100 | reverse conducting IGCT (RC-IGCT) |
| 110 | passivation oxide layer |
| 221 | first ring |
| 222 | second ring |
| 223 | third ring |
| 300 | reverse blocking IGCT (RB-IGCT) |
| 302 | thyristor cell |
| 310 | wafer |
| 323 | base semiconductor layer |
| 324 | drift semiconductor layer |
| 326 | first anode semiconductor layer |
| 400 | GTO (gate turn-off thyristor) |
| 402 | thyristor cell |
| 410 | wafer |
| 423 | base semiconductor layer |
| 424 | drift semiconductor layer |
| 426 | first anode semiconductor layer |
| 450 | anode short semiconductor region |

**Claims**

1. A Turn-off power semiconductor device comprising:

a wafer (10; 310; 410) having a first main side (11) and a second main side (12), which is arranged parallel to the first main side

(11);
a plurality of thyristor cells (2; 302; 402) arranged between the first main side (11) and the second main side (12), each of the plurality of thyristor cells (2; 302; 402) comprising in the order from the first main side (11) to the second main side (12):

(a) a first cathode electrode (21);
(b) a cathode semiconductor layer portion (22) of a first conductivity type;
(c) a base semiconductor layer (23; 323; 423) of a second conductivity type different from the first conductivity type;
(d) a drift semiconductor layer (24; 324; 424) of the first conductivity type;
(e) a first anode semiconductor layer (26; 326; 426) of the second conductivity type;
(f) a first anode electrode (27),

wherein each thyristor cell (2; 302; 402) further comprises a gate electrode (20) which is arranged lateral to the cathode semiconductor layer portion (22) and
contacting the base semiconductor layer (23; 323; 423),
wherein the cathode semiconductor layer portions (22) of the plurality of thyristor cells (2; 302; 402) form a first cathode semiconductor layer, and
wherein the gate electrodes (20) of the plurality of thyristor cells (2; 302; 402) are electrically connected with each other;
the device further comprising a common gate contact (40) for contacting the gate electrodes (20) of the plurality of thyristor cells (2; 302; 402), **characterized in that**
for each pair of a first thyristor cell and a second thyristor cell of the plurality of thyristor cells (2; 302; 402), for which a distance between the first thyristor cell and the common gate contact (40) is smaller than a distance between the second thyristor cell and the common gate contact (40), a minimum distance ($d_{1,min}$, $d_{2,min}$, $d_{3,min}$) between the gate electrode (20) and the cathode semiconductor layer portion (22) is smaller in the second thyristor cell than in the first thyristor cell,
wherein a distance ($d_1$, $d_2$, $d_3$) between the gate electrode (20) and the cathode semiconductor layer portion (22) is the distance in a lateral direction parallel to the first main side (11) between an edge of an interface area of the gate electrode (20) with the base semiconductor layer (23; 323; 423) and an edge of an interface area of the cathode semiconductor layer portion (22) with the base semiconductor layer (23; 323; 423).

**2.** The Turn-off power semiconductor device according to claim 1, wherein the common gate contact (40) is arranged in the center of the device on the first main side (11).

**3.** The Turn-off power semiconductor device according to claim 1 or 2, wherein the cathode semiconductor layer portions (22) of the plurality of thyristor cells (2; 302; 402) are arranged on the first main side (11) with rotational symmetry around the center of the device.

**4.** The Turn-off power semiconductor device according to any one of claims 1 to 3, wherein the cathode semiconductor layer portions (22) of the plurality of thyristor cells (2; 302; 402) are formed on the first main side (11) as strips placed in concentric rings (221, 222, 223) around the center of the device, the longitudinal axis of each strip extending along a radial direction which is a direction extending from the center of the device and parallel to the first main side (11).

**5.** The Turn-off power semiconductor device according to claim 4, wherein for each single ring (221, 222, 223) the layout of the thyristor cell (2; 302; 402) regarding the distance ($d_1$, $d_2$, $d_3$) between the gate electrode (20) and the cathode semiconductor layer portion (22) and regarding the length of the strip ($l_1$, $l_2$, $l_3$) is the same for all thyristor cells (2; 302; 402) of the respective single ring (221, 222, 223).

**6.** The Turn-off power semiconductor device according to claim 5, wherein the length of the strips ($l_1$, $l_2$, $l_3$) increases with increasing distance of the rings (221, 222, 223) from the center of the device.

**7.** The Turn-off power semiconductor device according to claim 5 or 6, wherein:

in each one of the plurality of thyristor cells (2) the distance ($d_1$, $d_2$, $d_3$) between the gate electrode (20) and the cathode semiconductor layer portion (22) is decreasing along the longitudinal axis of the cathode semiconductor layer portion (22) with increasing distance from the common gate contact (40) from a maximum distance ($d_{1,max}$, $d_{2,max}$, $d_{3,max}$) to the minimum distance ($d_{1,min}$, $d_{2,min}$, $d_{3,min}$) and
for each first and second ring, for which the first ring is closer to the common gate contact (40) than the second ring, the maximum distance in the second ring is equal or smaller than the minimum distance in the first ring.

**8.** The Turn-off power semiconductor device according to any one of claims 4 to 6, wherein in each one of the plurality of thyristor cells (2; 302; 402) the dis-

tance ($d_1$, $d_2$, $d_3$) between the gate electrode (20) and the cathode semiconductor layer portion (22) is constant along the longitudinal axis.

**9.** The Turn-off power semiconductor device according to any one of claims 1 to 8, wherein a serial resistance of the base semiconductor layer (23; 323; 423) connecting the gate electrode (20) with the cathode semiconductor layer portion (22) is decreasing with increasing distance of the thyristor cells (2) from the common gate contact (40), and wherein the decreasing serial resistance is adapted to compensate the difference in the voltage drop between the common gate contact (40) and the different gate electrodes (20) so that a current density of the turn-off current for the different thyristor cells (2; 302; 402) is equalised.

**10.** The Turn-off power semiconductor device according to any one of claims 1 to 9, wherein the cathode semiconductor layer portions (22) are surrounded in a plane parallel to the first main side (11) by a gate metallization layer forming the plurality of gate electrodes (20) and connections there between.

**11.** The Turn-off power semiconductor device according to claim 10, wherein the first main side (11) forms an upper side of the device and the second main side (12) is forms a lower side of the device and wherein the upper side of the gate metallization layer is on a level lower than the upper side of the cathode electrodes (21) of the plurality of thyristor cells (2; 302; 402).

**12.** The Turn-off power semiconductor device according to any one of claims 1 to 11, wherein the base semiconductor layer (23; 323; 423) between the cathode semiconductor layer portion (22) and the gate electrode (20) of each thyristor cell (2; 302; 402) is covered by a passivation oxide layer (110).

**13.** The Turn-off power semiconductor device according to any one of claims 1 to 12, wherein the first conductivity type is n-type and the second conductivity-type is p-type.

**14.** The Turn-off power semiconductor device according to any one of claims 1 to 13, wherein the turn-off power semiconductor device further comprises at least one diode cell (3) which comprises a second anode electrode (31) and a second anode semiconductor layer (32) of the second conductivity type, which is separated from the base semiconductor layer (23) by the drift semiconductor layer (24), on the first main side (11) and a second cathode semiconductor layer (33) of the first conductivity type on the second main side (12).

15. The Turn-off power semiconductor device according to any one of claims 1 to 14, each thyristor further comprising a buffer semiconductor layer (25) of the first conductivity type between the first anode semiconductor layer (26) and the drift semiconductor layer (24), wherein the doping concentration of the buffer semiconductor layer (25) is higher than that of the drift semiconductor layer (24).

FIG. 1

EP 2 930 753 A1

# FIG. 2

**FIG. 3**

# FIG. 4A

# FIG. 4B

EP 2 930 753 A1

# FIG. 5

16

# FIG. 6

FIG. 7

| | Europäisches Patentamt<br>European Patent Office<br>Office européen des brevets | **EUROPEAN SEARCH REPORT** | Application Number<br>EP 14 16 4075 |
| --- | --- | --- | --- |

## DOCUMENTS CONSIDERED TO BE RELEVANT

| Category | Citation of document with indication, where appropriate,<br>of relevant passages | Relevant<br>to claim | CLASSIFICATION OF THE<br>APPLICATION (IPC) |
| --- | --- | --- | --- |
| X | EP 0 283 588 A2 (BBC BROWN BOVERI AG)<br>28 September 1988 (1988-09-28)<br>* column 4, line 3 - column 8, line 29;<br>figures 1-6 *<br>* column 9, line 2 - line 20 *<br>----- | 1-15 | INV.<br>H01L29/744<br>H01L29/423 |
| A,D | EP 0 592 991 A1 (SIEMENS AG)<br>20 April 1994 (1994-04-20)<br>* page 3, line 13 - line 14; figure 1 *<br>----- | 6 | |
| A,D | WO 2012/041958 A2 (ABB TECHNOLOGY AG ET<br>AL) 5 April 2012 (2012-04-05)<br>* figures 1-6 *<br>----- | 14,15 | |
| | | | TECHNICAL FIELDS<br>SEARCHED (IPC)<br><br>H01L |

| The present search report has been drawn up for all claims | | |
| --- | --- | --- |
| Place of search<br>Munich | Date of completion of the search<br>11 September 2014 | Examiner<br>Morvan, Denis |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
......................................................................................
& : member of the same patent family, corresponding
   document

EPO FORM 1503 03.82 (P04C01)

**ANNEX TO THE EUROPEAN SEARCH REPORT
ON EUROPEAN PATENT APPLICATION NO.**

EP 14 16 4075

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2014

| Patent document cited in search report | | Publication date | Patent family member(s) | | Publication date |
|---|---|---|---|---|---|
| EP 0283588 | A2 | 28-09-1988 | CN | 88100671 A | 28-09-1988 |
| | | | DE | 3787721 D1 | 11-11-1993 |
| | | | EP | 0283588 A2 | 28-09-1988 |
| | | | JP | S63215074 A | 07-09-1988 |
| | | | US | 4843449 A | 27-06-1989 |
| EP 0592991 | A1 | 20-04-1994 | DE | 4234829 A1 | 21-04-1994 |
| | | | EP | 0592991 A1 | 20-04-1994 |
| | | | JP | 3571067 B2 | 29-09-2004 |
| | | | JP | H06204460 A | 22-07-1994 |
| WO 2012041958 | A2 | 05-04-2012 | CN | 103119715 A | 22-05-2013 |
| | | | EP | 2622639 A2 | 07-08-2013 |
| | | | JP | 2013543260 A | 28-11-2013 |
| | | | KR | 20130100144 A | 09-09-2013 |
| | | | US | 2013207157 A1 | 15-08-2013 |
| | | | WO | 2012041958 A2 | 05-04-2012 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012041958 A2
- EP 0592991 A1